(19) Europäisches Patentamt
European Patent Office
Office européen des brevets

(11) EP 1 055 641 A2

(12) **EUROPEAN PATENT APPLICATION**

(43) Date of publication:
29.11.2000 Bulletin 2000/48

(51) Int Cl.⁷: **C01B 31/36**, C22C 29/06, H01L 23/34

(21) Application number: 00304501.0

(22) Date of filing: 26.05.2000

(84) Designated Contracting States:
**AT BE CH CY DE DK ES FI FR GB GR IE IT LI LU MC NL PT SE**
Designated Extension States:
**AL LT LV MK RO SI**

(30) Priority: **28.05.1999 JP 14902699**

(71) Applicant: **Sumitomo Electric Industries, Ltd. Osaka-shi, Osaka 541-0041 (JP)**

(72) Inventor: **Kawai, Chihiro,
c/o Itami Works of Sumitomo
Itami-shi, Hyogo (JP)**

(74) Representative:
**Cross, Rupert Edward Blount et al
BOULT WADE TENNANT,
Verulam Gardens
70 Gray's Inn Road
London WC1X 8BT (GB)**

(54) **Silicon carbide powder and composite material made thereof and method for manufacturing the powder and material**

(57) A highly heat-conductive silicon carbide powder particularly useful for manufacturing heat-dissipating substrates and other members for semiconductor devices, and a silicon carbide-based composite material made with the silicon carbide powder. The silicon carbide powder is characterized in that the summation of the peak intensities of X-ray diffraction peaks obtained on the (101), (102), (103), (104), and (110) planes of 6H-type crystal grains in the range of Bragg angle 2Θ from 30 to 61 degrees in the X-ray diffraction chart is 90% or more of the summation of the peak intensities of all the X-ray diffraction peaks in the same range of Bragg angle as above when tested by using the CuKα line. The silicon carbide-based composite material is obtained by compounding the silicon carbide powder with a metal powder such as an aluminum powder. The silicon carbide powder is obtained by the following method: First, a silicon carbide material powder is prepared. Second, a seed crystal powder, having an average particle diameter larger than that of the silicon carbide material powder, containing 98% or more 6H-type crystal particles is added to the silicon carbide material powder to prepare a mixed powder. Finally, the mixed powder is heat-treated at 1,800 °C or higher in an inert gas.

FIG. 1

EP 1 055 641 A2

**Description**

The present invention relates to a highly heat-conductive silicon carbide powder and to a composite material, having particles of the powder dispersed in its metal matrix, useful for a heat-dissipating substrate for various devices and machines, particularly for semiconductor devices. The present invention also relates to a semiconductor device made with the composite material. The present invention further relates to a method for manufacturing the silicon carbide powder and the composite material.

More highly integrated semiconductor devices operating at a higher rate have been in urgent demand in the market in recent years. Under these circumstances, heat-dissipating substrates for mounting semiconductor elements in semiconductor devices have been required to further increase their thermal conductivity in order to more effectively dissipate the heat generated by the elements. Furthermore, the heat-dissipating substrates have been required to have a coefficient of thermal expansion (hereinafter called CTE) that is further comparable to that of the semiconductor elements and other members (peripheral members) adjacent to the heat-dissipating substrates in the semiconductor device in order to further reduce the thermal strain between them and the heat-dissipating substrates. More specifically, Si and GaAs, usually used as a semiconductor element, have a CTE of $4.2 \times 10^{-6}/°C$ and $6.5 \times 10^{-6}/°C$, respectively. Alumina ceramics, usually used as an enveloping material for semiconductor devices, have a CTE of $6.5 \times 10^{-6}/°C$ or so. It is desirable that the heat-dissipating substrates have a CTE comparable to those values.

Semiconductor devices have been used in further diversified applications with the significant expansion of electronic device applications in recent years. Among these applications, semiconductor devices have been increasingly used as semiconductor power devices such as high-output dc/ac converters and frequency changers. Semiconductor elements in these semiconductor power devices generate heat no less than several to several-dozen times that generated by semiconductor memories or microprocessors (the semiconductor element usually generates tens of watts). Therefore, it is essential for the heat-dissipating substrates used in these power devices not only to further increase the thermal conductivity but also to have an increased CTE of equivalent quality with that of the peripheral members. Consequently, semiconductor power devices usually have the following basic structure: First, one or more Si semiconductor elements are mounted on the first heat-dissipating substrate, a highly heat conductive aluminum nitride (hereinafter also called AlN) ceramic substrate. Second, the second heat-dissipating substrate made of a metal, which is more highly heat conductive, such as copper is placed underneath the first heat-dissipating substrate. Finally, a heat-dissipating mechanism that can be cooled by air or water is placed underneath the second heat-dissipating substrate. Such a structure enables the heat dissipation to the outside without delay. The structure, therefore, inevitably has a complicated heat-dissipating structure. In this structure, when the first heat-dissipating substrate, an AlN ceramic, has a thermal conductivity of 170 W/m·K or so, the second heat-dissipating substrate must have a thermal conductivity as high as 200 W/m·K or more at room temperature in order to promptly conduct the heat from the first substrate to the heat-dissipating mechanism underneath. The second heat-dissipating substrate is also required to have a CTE as low as $10 \times 10^{-6}/°C$ or less, preferably $8 \times 10^{-6}/°C$ or less, in order to match its CTE with that of the first substrate.

Such a substrate has been usually made of a Cu-W- or Cu-Mo-based composite alloy, for example. These substrates have the drawback of high costs resulting from high material costs and of heavy weight. To solve these problems, attention has been focused on various aluminum (hereinafter also called Al) composite alloys in recent years, because these alloys are low in costs and light in weight. Among these alloys, an Al-SiC-based composite alloy consisting mainly of Al and silicon carbide (hereinafter also called SiC) has the advantages of the availability of materials at relatively low costs, light weight, and high heat conductiveness. Pure single bodies of Al and SiC usually available in the market have a density of 2.7 g/cm$^3$ or so and 3.2 g/cm$^3$ or so, respectively, and a thermal conductivity up to 240 W/m · K or so and 200 to 300 W/m · K or so, respectively. The thermal conductivity of these materials are likely to be increased if the purity and defect concentration are adjusted. This is the reason the materials are particularly noted. Pure single bodies of Al and SiC have a CTE of $24 \times 10^{-6}/°C$ or so and $4.2 \times 10^{-6}/°C$ or so, respectively. Their CTE can be controlled in a wide range by compounding the two materials. They are also advantageous in this regard.

Such Al-SiC-based composite alloys and manufacturing methods for the alloys have been disclosed in published Japanese patent applications *Tokukaihei* 1-501489, (1), *Tokukaihei* 2-243729, (2), *Tokukaishou* 61-222668, (3), and *Tokukaihei* 9-157773, (4). Of these, (1) relates to a method in which Al in an SiC-Al mixture is melted to solidify by casting. Both (2) and (3) relate to a method in which Al is infiltrated into the pores of an SiC porous body. Of these, (3) relates to the pressure infiltration method, in which Al is infiltrated under pressure. (4) relates to a method in which a preformed body of an Al-SiC-mixed powder is placed in a mold to be formed and sintered in a vacuum at a temperature not lower than the melting point of Al and to a method in which the preformed body is placed in a mold to be pressure-sintered with a method such as hot pressing in a vacuum at a temperature not lower than the melting point of Al.

Published Japanese patent application *Tokukaihei* 10-335538, (5), discloses an aluminum-silicon carbide-based composite material, obtained by the liquid phase sintering method, having a thermal conductivity of 180 W/m·K or more. The composite material is obtained by the following method: First, for example, 10 to 70 wt. % grained SiC powders and remaining grained Al powders are mixed. Second, the mixture is formed. Finally, the formed body is sintered at 600 to 750 °C in a non-oxidizing atmosphere containing 99% or more nitrogen, having an oxygen concentration of 200 ppm or less, and having a clew point of - 20 °C or lower.

Published Japanese patent application *Tokukaihei* 10-280082, (6), discloses a net-shape aluminum-silicon carbide-based composite material (sintering of this material produces dimensions that are close to the final dimensions). The material has a CTE of $18 \times 10^{-6}/°C$ or less and a thermal conductivity of 230 W/m·K or more.

In published Japanese patent application *Tokukaihei* 11-310843, (7), the present inventor et al disclose a method for manufacturing an Al-SiC-based composite material. The method combines the atmospheric-pressure sintering method and the hot isostatic pressing (HIP) method. The composite material is obtained by the following method: First, for example, 10 to 70 wt. % grained SiC powders and remaining grained Al powders are mixed. Second, the mixture is formed. Third, the formed body is atmospheric pressure-sintered in a non-oxidizing atmosphere, containing 99% or more nitrogen gas, at a temperature not lower than 600 °C and not higher than the melting point of Al. Finally, the sintered body is sealed in a metal container to be isostatically hot-pressed at 700 °C or higher. The method produces a homogeneous aluminum-silicon carbide-based composite material having a thermal conductivity of 200 W/m·K or more.

Published Japanese patent application *Tokukaihei* 9-157773, (4), discloses a method in which a mixture of Al powders and SiC powders is hot-pressed for simultaneous formation and sintering. The method is as follows: First, 10 to 80 vol. % Al powders and remaining SiC powders are mixed. Second, the mixture is preformed. Finally, the preformed body is hot-pressed at a temperature not lower than the melting point of Al and a pressure not lower than 500 kg/cm². This method produces an aluminum-silicon carbide-based composite material having a thermal conductivity of 150 to 280 W/m·K.

When the foregoing composite materials are intended for use as a substrate that must dissipate a large amount of heat, especially, as a substrate of a relatively large size for dissipating a large amount of heat, such as a substrate for semiconductor power devices, the foregoing composite materials still have disadvantages to be solved as described below.

The method described in (1) above produces an Al-SiC-based composite material by the casting method in which molten Al is poured into a mold to disperse the SiC powders before solidification. In this case, the density difference between the Al and SiC easily produces the segregation of SiC particles in the formed body during the cooling, producing uneven composition in the solidified body. As a result, the surface of the solidified body is inevitably covered with a layer made of Al or Al alloy. Usually, the thickness of the covered layer varies considerably with the position on the surface of the solidified body. In addition, the considerable difference in the CTE between the surface portion (the covered layer) of the solidified body and the interior produces thermal stresses there when heat is conducted to the interface between the two. Consequently, if the material is used as a heat-dissipating substrate for mounting semiconductor elements without removing this covered layer, then the heat stresses produce warping and distortion in the substrate. This causes cracks in the semiconducfor elements or between the peripheral members and the substrate. This also causes distortion or fracture of the semiconductor elements or the peripheral members. Therefore, the covered layer must be removed completely before use. However, this removal is extremely difficult, because the abovementioned fluctuation in the thickness of the covered layer leads to the machining of the coexisting portion of a phase consisting mainly of soft, ductile Al and a phase containing highly stiff SiC.

The methods described in (2) and (3) above produce an Al-SiC-based composite material by infiltrating Al into the pores of an SiC porous body. In this case, the molten Al must be prevented from generating shrinkage cavities such as those generated in the casting of steel. The Al must also be filled completely into the pores of the SiC porous body to produce a dense composite alloy. Consequently, an excess amount of Al is usually provided as an infiltrant around the SiC porous body. After the infiltration, the excess Al elutes over the surface of the infiltrated body to adhere there. Removal of this excess Al requires considerable time and effort. In the method described in (5) above, a mixed powder consisting mainly of Al and SiC is formed for sintering. In this case also, if sintering is carried out at a temperature exceeding the melting point of Al, a phenomenon similar to the above occurs, although to a modest degree.

To prevent the Al from eluting over the surface of the infiltrated body to adhere there, the method described in (6) above is applied and forms a thin layer comprising a mixture of elution-preventing agents and infiltration-promoting agents over the surface of the SiC porous body before Al is infiltrated. However, the application of this layer and its removal after the infiltration require considerable time and effort.

The pressure infiltration method described in (3) above comprises the following steps: An SiC porous body is placed in a mold that enables uniaxial pressuring. Pieces of Al or Al alloy are placed on the SiC porous body. While the Al is melted in a vacuum, external uniaxial pressure forces the Al to fill the SiC porous body. Finally, the infiltrated body is gradually cooled from the bottom with a temperature graduation. During this cooling process, a large difference in the CTE between the SiC framework portion at the interior of the infiltrated body and the Al-filled portion easily produces portions where no Al exists (these portions are the foregoing shrinkage cavities). This is caused by the shrinkage of Al in the infiltrated body at the time of cooling. Prevention of these shrinkage cavities requires a complicated mechanism that simultaneously controls both the temperature graduation at the time of cooling and the program for pressurizing and heating with precision. This control mechanism is extremely expensive.

The in-a-mold hot-press method described in (4) above poses problems in production and quality as described below. For instance, if a continuous hot press system is used, the molten material must be prevented from flowing out of the mold in order to maintain the vacuum atmosphere and to raise the temperature to reach or exceed the melting point of Al. Consequently, suppression of variation in the amount of constituent for obtaining the intended uniform composition requires extremely expensive manufacturing equipment. On the other hand, the use of a batch system rather than the continuous system facilitates to some extent the prevention of molten material flowing out of the mold. However, this system requires intermittent repetition of a series of steps such as loading of a formed body into a mold and maintaining and cooling of the mold according to the given temperature program. Thus, this method is poor in productivity.

As detailed above, the manufacturing of conventional metal-SiC-based composite materials represented by Al-SiC-based composite materials has problems in quality and production. Consequently, Al-SiC-based composite materials have not been produced with a satisfactory, targeted performance level by conventional methods, such as casting, infiltration, sintering, hot-pressing, and combinations thereof, although Al-SiC-based composite materials have been attracting attention with their performances as a substrates especially for semiconductor power modules that require a highly heat-dissipating quality.

The thermal conductivity $K$ of such a metal-SiC-based composite material is expressed in the following equation when the thermal conductivity of the metal that forms the matrix is represented by $Km,$ the thermal conductivity of the SiC particles that constitute the dispersed phase $Kd,$ and the volume percentage of the dispersed phase $Vd.$

$$K = Km[1 + 2\,Vd(R - 1)/(R - 2)]/[1 + Vd(1 - R)/(R + 2)],$$

where $R = Kd/Km.$

As can be seen in the above equation, when $Vd$ hecomes larger, $Kd$, in particular, affects the thermal conductivity $K$ of the composite material considerably. On the other hand, the thermal conduction in ceramic particles such as SiC is carried out by the conduction of phonons. Therefore, the promotion of their thermal conduction requires the suppression of factors that scatter phonons. Of these factors, one of the important factors is the crystal type of SiC.

To solve the above-described problems, the present inventor conducted further study to complete the present invention. The present invention offers a silicon carbide (SiC) powder of which the summation of the peak intensities of X-ray diffraction peaks obtained on the (101), (102), (103), (104), and (110) planes of 6H-type crystal grains in the range of Bragg angle $2\Theta$ from 30 to 61 degrees is 90% or more of the summation of the peak intensities of all the X-ray diffraction peaks in the same range of Bragg angle when tested by using the CuK$\alpha$ line. The peak intensity ratio is equivalent to the content of GH-type crystal grains in the powder. The present invention also calls this ratio "the 6H content degree" of an SiC powder.

It is desirable that the SiC powder of the present invention have an average particle diameter of 0.1 to 200 $\mu$m. The present invention includes a composite material in which particles of the foregoing SiC powder are dispersed in the metal matrix. The present invention also includes a composite material, in particular, in which particles of the foregoing SiC powder having an amount of 50 to 90 wt. % are dispersed in the matrix of metal consisting mainly of aluminum. The present invention also includes a semiconductor device made with such a composite material.

The silicon carbide powder of the present invention is obtained by the following method: First, a silicon carbide material powder is prepared. Second, a seed crystal powder, having an average particle diameter larger than that of the silicon carbide material powder, containing 98% or more 6H-type crystal particles (6H content degree: 98% or more) is added to the silicon carbide material powder to prepare a mixed powder. Finally, the mixed powder is heat-treated at 1,800 °C or higher in an inert gas. The method includes the following specific methods:

    (a) a method in which the seed crystal powder contains 100 ppm or less Fe;
    (b) a method in which the seed crystal powder has an average particle diameter two or more times that of the silicon carbide material powder;
    (c) a method in which the silicon carbide material powder has an average particle diameter of 10 $\mu$m or less; and
    (d) a method in which the added amount of the seed crystal powder is 5 wt. % or more of the total amount of the mixed powder.

In the present invention, the term "a silicon carbide (SiC) material powder" is used to mean the starting material to which a seed crystal powder is added before the heat treatment. In contrast, the term "a silicon carbide (SiC) powder" is used to mean a powder obtained by the heat treatment.

The composite material of the present invention is obtained by the following method: a silicon carbide powder obtained by the foregoing method is mixed with a metal powder. The mixed powder is formed. Finally, the formed body is sintered by heating at a temperature not lower than the melting point of the metal. This method can be called a sintering method. The composite material of the present invention is also obtained by the following method: The foregoing silicon carbide powder is formed. Then, the pores of the formed body is infiltrated with a molten metal. This method can be called an infiltration method. With the sintering method, the sintering is usually carried out in a non-oxidizing atmosphere. Nevertheless, this may be carried out in the air if the sintering time is short. Pressure sintering such as hot-pressing or forging may also be employed. With the infiltration method, the infiltration is carried out in a non-oxidizing atmosphere. In the present invention, when the metal powder consists mainly of aluminium, it is desirable that the silicon carbide powder have an amount of 50 to 90 wt. %.

The present invention offers a silicon carbide powder having a 6H content degree of 90% or more. The powder is produced by the following method: First, a silicon carbide material powder is prepared. Second, a silicon carbide seed crystal powder, having an average particle diameter larger than that of the silicon carbide material powder and a 6H content degree of 98% or more, is added to the silicon carbide material powder to prepare a mixed powder. Finally, the mixed powder is heat-treated at 1,800 °C or higher in an inert gas atmosphere to condense and deposit 6H-type silicon carbide crystal particles on the seed crystal particles. The silicon carbide powder has excellent thermal conductivity. More specifically, its thermal conductivity at room temperature is 250 W/m·K or more. Compounding the powder with a metal such as aluminum easily produces a composite material having as excellent thermal conductivity as the powder. The composite material has unprecedented high thermal conductivity even when the amount of SiC is 50 wt. % or more. This amount of SiC is employed in a composition to produce a low CTE. The composite material has excellent matching quality in CTE with semiconductor elements and other members in semiconductor devices. Therefore, the members made of this composite material can be used satisfactorily in semiconductor devices used under severe conditions, such as high-output power modules.

In the drawings, provided by way of example:

Figure 1 is a schematic illustration showing a semiconductor device (power module) incorporating the composite material of the present invention as the substrate.

Figure 2 is a schematic illustration showing the manufacturing process of the silicon carbide powder of the present invention.

The silicon carbide (SiC) powder of the present invention is obtained by the above-mentioned method. The seed crystal powder is a powder containing 98% or more 6H-type crystal particles (6H content degree: 98% or more). A 6H-type SiC crystal is highly symmetrical and seldom scatters phonons in nature in comparison with other crystal types such as 15R- or 4H-type. Therefore, it is desirable to increase the 6H content degree of the crystals deposited by the succeeding heat treatment. In order to achieve this, it is desirable to use a 6H-type seed crystal powder, which acts as the nucleus of the crystal. If the seed crystal powder contains a large amount of transition element-including impurities (cation impurities), the number of defects increases in the crystal particles obtained by the heat treatment, thereby decreasing the thermal conductivity. Consequently, it is desirable to decrease the cation impurities to the extent possible. Among these cation impurities, it is desirable to reduce the amount of Fe to 100 ppm or less.

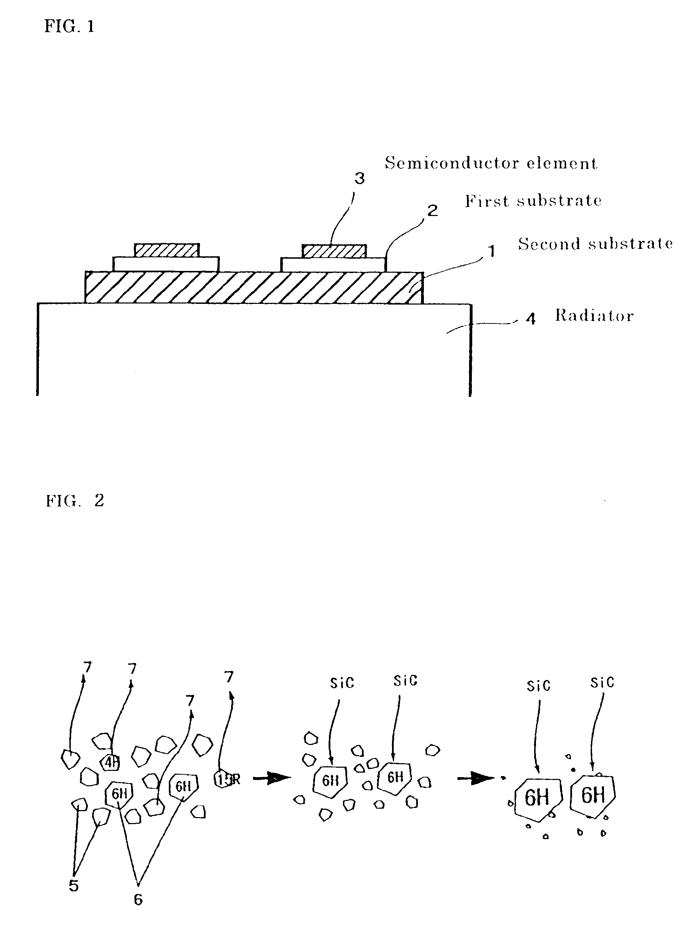

An SiC material powder consisting mainly of 6H-type crystal particles may be used as the starting material. Other SiC powders may also be used that contain some other crystal types such as 4H and 15R, that contain Fe and other cation impurities, that contain defects, or that are available at low cost. For example, low-cost powders for abrasive grains may be used. In the present invention, first, the foregoing seed crystal powder is added to such an ordinary powder to prepare a mixed powder. Then, the mixed powder is heated at 1,800 °C or higher in a non-oxidizing atmosphere. First, during the course of the temperature rising up to 1,800 °C, the impurities absorbed on the surface of or included in the particles of the seed crystal powder and SiC material powder are sublimated. Then, when heated at 1,800 °C or higher, SiC begins to be sublimated from the surface of the particles of the seed crystal powder and material powder. Because the material powder has a smaller average particle diameter than that of the seed crystal powder, SiC is sublimated preferentially in the material powder. Gases, such as $Si_2C$, $SiC_2$, and Si, produced by the sublimation of SiC are condensed and solidified. Crystal nuclei for the solidification tend to develop on the surface of the particles of the seed crystal powder, which has less sublimation. Because the surface of the particles of the seed crystal powder has few defects, 6H-type crystal particles having an extremely small number of defects are formed on the surface. During the course of the heat treatment, such a process of sublimation and condensation of SiC is repeated. This process is shown schematically in Fig. 2, where 5 represents particles of the material powder, 6 particles of the seed crystal powder, and 7 particles of gases, such as $Si_2C$, $SiC_2$, and Si, produced by the sublimation of SiC from the particles of these powders.

To promote this process, it is desirable that the seed crystal powder have an average particle diameter larger than that of the material powder, more desirably 2 or more times that of the material powder, preferably 5 or more times that of the material powder. By the same reason, it is desirable that the material powder have an average particle diameter as small as possible, preferably 10 μm or less. These conditions promote the rate of transition to the 6H type even with a reduced number of cycles of the above-described sublimation and condensation. This shortens the heating time. The seed crystals of the present invention may be prepared by several methods. For example, when highly pure SiC crystals produced by the CVD method are added to the seed crystal powder, a highly heat-conductive SiC powder with further increased purity and reduced defects can be obtained. The heat treatment is carried out in the atmosphere of an inert gas, such as argon, nitrogen, or helium. However, nitrogen gas tends to produce more defects in the crystals deposited by the condensation than argon does. Helium gas is expensive. Thus, argon gas is preferable. The atmospheric gas may have a pressure up to atmospheric pressure or so. A gas pressure exceeding atmospheric pressure retards the sublimation of SiC. The heat treatment is carried out at a temperature not lower than 1,800 °C, at which temperature SiC begins to sublimate and impurities sublimate sufficiently. It is desirable that the heat-treating temperature be 2,000 °C or higher. It is also desirable that the heat-treating temperature not be higher than 2,400 °C, at which temperature SiC begins to sublimate violently. When the heat-treating temperature exceeds 2,400 °C, it is difficult to recover the SiC as a solid.

It is desirable that the added amount of the seed crystal powder is 5 wt. % or more of the total amount of the mixed powder. If less than 5 wt. %, the 6H content degree of the SiC by the foregoing heat treatment easily decreases. It is desirable to increase the added amount as much as possible. However, high-purity powders are expensive. It is economical to increase the amount to 50 wt. % at most. The 6H content degree of the SiC powder of the present invention is confirmed by the peak ratio in the X-ray diffraction chart of the powder as previously explained. The diffraction peak obtained on the (110) plane is divided into the $CuK\alpha_1$ peak and the $CuK\alpha_2$ peak. The 6H content degree is determined by using the $CuK\alpha_1$ peak only. The SiC powder of the present invention thus obtained has a 6H content degree of 90% or more. If less than 90%, the thermal conductivity cannot be increased effectively. It is desirable that the SiC powder have an average particle diameter of 0.1 to 200 μm, depending on the average particle diameter of the material powder. The growth of the SiC particles during the heat treatment usually results in an average particle diameter of 0.1 μm or more. If more than 200 μm, formation of the powder may be difficult. The quantity of the cation impurities in the SiC crystals is determined by the following method. For example:this case, the target impurity is Fe. First, an SiC powder is immersed in aqua regia with the intention of avoiding the dissolution of the SiC itself. Then, Fe existing outside the SiC crystals in the powder is dissolved to make a solution. Next, another SiC powder is immersed in a mixed solution of hydrofluoric acid HF and nitric acid $HNO_3$, which solution can also dissolve SiC. Then, all of the Fe contained in the powder is dissolved to make another solution. Finally, the difference in the quantity of the dissolved Fe between the two solutions is determined.

The composite material of the present invention is produced by dispersing the foregoing particles of SiC powder into a metal matrix. As previously mentioned, the composite material is obtained by mixing the foregoing SiC powder and a metal powder, forming the mixed body, and sintering the formed body by heating at a temperature not lower than the melting point of the metal. The composite material is also obtained by forming an SiC powder and infiltrating a metal into the pores of the formed body. It is desirable to use a metal consisting mainly of copper, aluminum, or silver. They are relatively low in cost and high in thermal conductivity. Copper has a density of 8.9 g/cm$^3$ or so, a thermal conductivity of 395 W/m·K or so, and a CTE of 17 $\times$ 10$^{-6}$/°C or so. Silver has a density of 10.5 g/cm$^3$ or so, a thermal conductivity of 418 W/m·K or so, and a CTE of 19.7 $\times$ 10$^{-6}$/°C or so. Of these metals, it is desirable to use a metal consisting mainly of aluminum, which is lowest in cost and lightest in weight. It is desirable that the amount of SiC be 50 to 90 wt. %. In the case of the sintering method, however, it is desirable that the amount not be more than 80 wt. %, in terms of the sintering quality. If less than 50 wt. %, the CTE differs largely from that of semiconductor elements such as Si or GaAs. If more than 90 wt. %, the infiltration method has a problem in that the molten metal cannot be easily infiltrated into the pores of the SiC porous body. The amount of SiC should be properly selected in accordance with the required level of properties such as thermal conductivity, a CTE, and electrical characteristics. The above description on the amount of SiC and the procedure for controlling thermal and electrical properties can be applied without much modification to a composite material made with a metal other than Al, i.e., Cu or Ag.

The sintering is usually carried out in a non-oxidizing atmosphere. Nevertheless, this may be carried out in the air if the sintering time is short. Pressure sintering such as hot pressing may also be employed. It is preferable to heat the formed body previously in a heating apparatus such as a high-frequency induction heater, which can heat the formed body quickly and uniformly, and to hot-forge the pre-heated formed body in a pre-heated mold. This method can suppress the interfacial reaction between the SiC and metal, and thereby minimize the reduction in thermal conductivity caused by the reaction products. The recommended manufacturing method of the present invention stably produces composite materials having a high thermal conductivity exceeding 250 W/m·K even when the amount of the SiC is 50 wt. % or more in the case of an Al-SiC-based composite material, for example. In particular, when a fine SiC material powder having an average particle diameter of 0.1 to several micrometers is used for preparing a composite material, a product excellent in thermal conductivity can be obtained. The above description can be applied without much modification to a composite material made with a metal other than Al, i.e., Cu or Ag.

The composite material of the present invention having excellent thermal conductivity can be widely used as a member for various apparatus and machines that require highly heat-dissipating quality, such as electric and electronic devices and cars. The composite material is particularly useful as various members such as heat sink material and enveloping material of semiconductor devices. Even with a composition having an SiC content as high as 50 wt.

% or more, particularly as high as 70 wt. % or more, a composite material having high thermal conductivity can be easily obtained. As a result, the composite material combines high thermal conductivity and a relatively low CTE. Therefore, the composite material of the present invention has superior quality for compatibility with various component parts that have a relatively low CTE such as semiconductor elements used in semiconductor devices. Consequently, as described in Examples below, the composite material can withstand severe heat cycles in practical applications. This indicates that the composite material has sufficient properties to be used as a heat sink for high-output power modules previously described, for example.

Example 1

The following materials were prepared:

(a) silicon carbide material powders having an average particle diameter shown in the column "starting material" in Table 1, having a 6H content degree of 80%, and containing 15R-, 33R-, and 4H-type crystal particles in addition to 6H type; and
(b) seed crystal powders having an Fe content, an average particle diameter, and a 6H content degree respectively shown in the columns "Fe content", "average particle diameter", and "6H content degree" in Table 1.

These powders were dry-mixed in a proportion such that a seed crystal powder has a weight percentage shown in the column "added amount" under the column "seed crystal powder" in Table 1 and one of the above-described silicon carbide material powders constitutes the remaining part. Then, the mixture was placed in a silicon carbide container to place in a furnace having tungsten heaters. The mixture was heat-treated by the following program:

(a) The mixture was heated up to 1,800 °C from room temperature at a rate of 20 °C/min in a vacuum of 0.01 torr. (Samples 1 and 20 were differently treated as shown in Table 1.)
(b) Argon gas was introduced into the furnace until the pressure reached atmospheric pressure.
(c) The temperature was raised to a temperature shown in the column "heat treatment temperature" in Table 1 at a rate of 20 °C/min.
(d) The temperature was maintained for 2 hours.
(e) The heat-treated mixture was self-cooled.

Two one-gram samples were sampled from each of the heat-treated powders. One sample was immersed in 100 ml of aqua regia at room temperature for 20 hours. The other sample was immersed in 100 ml of a mixed solution of hydrofluoric acid HF and nitric acid $HNO_3$ with a ratio of 3 : 1 at 150 °C for 20 hours. The quantity of Fe dissolved in each solution was determined via emission spectrochemical analysis. As previously mentioned, the quantity of Fe in the crystal particles of the SiC powder was determined by the difference in the quantity of Fe between the two solutions. X-ray diffraction charts in the range of Bragg angle from 30 to 61 degrees were obtained by using the CuK$\alpha$ line. In accordance with the procedure explained previously, the 6H content degree of each powder was determined by the peak intensity ratio. These results are shown in the column "heat-treated SiC powder" in Table 1 together with the average particle diameter. Table 4 shows the data of the intensity of diffraction peaks in the range of Bragg angle from 30 to 61 degrees of Sample 18.

Table 1

| Sample No. | Seed crystal powder: Avg particle diameter a (μm) | Seed: 6H content degree (%) | Seed: Fe content (ppm) | Seed: Added amount (wt%) | Material powder: Avg diameter b (μm) | Particle diameter ratio a/b | Heat treatment temperature (°C) | Heat-treated SiC: Avg particle diameter (μm) | HT SiC: 6H content degree (%) | HT SiC: Fe content (ppm) | SiC (wt%) | SiC (vol%) | Metal | Baking temperature (°C) | Relative density (%) | Thermal conductivity (W/m·K) | CTE (/°C) | Remarks |
|---|---|---|---|---|---|---|---|---|---|---|---|---|---|---|---|---|---|---|
| *1 | No seed crystals were added. | | | | 10 | - | No heat treatment | 10 | 80 | 350 | 70 | 66.6 | Al | 770 | 100 | 213 | $7.9 \times 10^{-6}$ | No seed crystal, no heat treatment |
| *2 | No seed crystals were added. | | | | 10 | - | 2,000 | 9 | 85 | 100 | 70 | 66.6 | Al | 770 | 100 | 263 | $7.9 \times 10^{-6}$ | No seed crystal |
| *3 | 50 | 96 | 90 | 10 | 10 | 5 | 2,000 | 9 | 89 | 140 | 70 | 66.6 | Al | 770 | 100 | 250 | $7.9 \times 10^{-6}$ | Seed crystal: 6H content degree < 98% |
| *4 | 50 | 98 | 90 | 10 | 52 | 0.96 | 2,000 | 49 | 86 | 150 | 70 | 66.6 | Al | 770 | 100 | 240 | $7.9 \times 10^{-6}$ | a/b < 1 |
| 5 | 50 | 98 | 90 | 10 | 10 | 5 | 2,000 | 9 | 95 | 4 | 70 | 66.6 | Al | 770 | 100 | 335 | $7.9 \times 10^{-6}$ | Effects of particle diameters of seed crystal and material, and of the ratio between the two |
| 6 | 50 | 99.5 | 90 | 10 | 9 | 5.6 | 2,000 | 9 | 95.5 | 4 | 70 | 66.6 | Al | 770 | 100 | 350 | $7.9 \times 10^{-6}$ | |
| 7 | 210 | 99.5 | 90 | 10 | 30 | 7 | 2,000 | 29 | 96 | 50 | 70 | 66.6 | Al | 770 | 100 | 265 | $7.9 \times 10^{-6}$ | |
| 8 | 200 | 99.5 | 90 | 10 | 20 | 10 | 2,000 | 19 | 97 | 40 | 70 | 66.6 | Al | 770 | 100 | 290 | $7.9 \times 10^{-6}$ | |
| 9 | 50 | 99.5 | 90 | 10 | 25 | 2 | 2,000 | 19 | 92 | 90 | 70 | 66.6 | Al | 770 | 100 | 300 | $7.9 \times 10^{-6}$ | |
| 10 | 38 | 99.5 | 90 | 10 | 20 | 1.9 | 2,000 | 36 | 90 | 100 | 70 | 66.6 | Al | 770 | 100 | 280 | $7.9 \times 10^{-6}$ | |
| 11 | 5 | 99.5 | 90 | 10 | 1 | 5 | 2,000 | 1 | 96 | 3 | 70 | 66.6 | Al | 770 | 100 | 355 | $7.9 \times 10^{-6}$ | |
| 12 | 5 | 99.5 | 90 | 10 | 0.1 | 50 | 2,000 | 0.1 | 98 | 2 | 70 | 66.6 | Al | 770 | 100 | 365 | $7.9 \times 10^{-6}$ | |
| 13 | 4.8 | 99.5 | 90 | 10 | 0.08 | 60 | 2,000 | 0.08 | 98 | 2 | 70 | 66.6 | Al | 770 | 100 | 370 | $7.9 \times 10^{-6}$ | |
| 14 | 50 | 99.5 | 110 | 10 | 10 | 5 | 2,000 | 9 | 96 | 8 | 70 | 66.6 | Al | 770 | 100 | 320 | $7.9 \times 10^{-6}$ | Effect of Fe content in seed crystal |
| 15 | 50 | 99.5 | 50 | 10 | 10 | 5 | 2,000 | 9 | 96 | 3 | 70 | 66.6 | Al | 770 | 100 | 345 | $7.9 \times 10^{-6}$ | |
| 16 | 50 | 99.5 | 90 | 10 | 10 | 5 | 2,000 | 9 | 96 | 4 | 70 | 66.6 | Al | 770 | 100 | 335 | $7.9 \times 10^{-6}$ | |
| 17 | 50 | 99.5 | 90 | 7 | 10 | 5 | 2,000 | 9 | 96 | 4 | 70 | 66.6 | Al | 770 | 100 | 335 | $7.9 \times 10^{-6}$ | Effect of added amount of seed crystal |
| 18 | 50 | 99.5 | 90 | 5 | 10 | 5 | 2,000 | 9 | 91 | 80 | 70 | 66.6 | Al | 770 | 100 | 300 | $7.9 \times 10^{-6}$ | |
| 19 | 50 | 99.5 | 90 | 4 | 10 | 5 | 2,000 | 9 | 91 | 100 | 70 | 66.6 | Al | 770 | 100 | 270 | $7.9 \times 10^{-6}$ | |
| *20 | 50 | 99.5 | 90 | 10 | 10 | 5 | 1,700 | 10 | 82 | 200 | 70 | 66.6 | Al | 770 | 100 | 225 | $7.9 \times 10^{-6}$ | Effect of heat treatment temperature |
| 21 | 50 | 99.5 | 90 | 10 | 10 | 5 | 1,800 | 10 | 90 | 100 | 70 | 66.6 | Al | 770 | 100 | 250 | $7.9 \times 10^{-6}$ | |
| 22 | 50 | 99.5 | 90 | 10 | 10 | 5 | 2,000 | 9 | 96 | 5 | 70 | 66.6 | Al | 770 | 100 | 330 | $7.9 \times 10^{-6}$ | |
| 23 | 50 | 99.5 | 90 | 5 | 10 | 5 | 2,000 | 9 | 93 | 80 | 48 | 44.1 | Al | 770 | 100 | 280 | $11.2 \times 10^{-6}$ | Effect of the amount of SiC in composite material |
| 24 | 50 | 99.5 | 90 | 5 | 10 | 5 | 2,000 | 9 | 93 | 80 | 50 | 46.1 | Al | 770 | 100 | 282 | $11.0 \times 10^{-6}$ | |
| 25 | 50 | 99.5 | 90 | 5 | 10 | 5 | 2,000 | 9 | 93 | 80 | 80 | 77.4 | Al | 770 | 100 | 310 | $6.5 \times 10^{-6}$ | |
| 26 | 50 | 99.5 | 90 | 5 | 10 | 5 | 2,000 | 9 | 93 | 80 | 90 | 88.5 | Al | 770 | 100 | 320 | $5.3 \times 10^{-6}$ | |
| 27 | 50 | 99.5 | 90 | 5 | 10 | 5 | 2,000 | 9 | 93 | 80 | 92 | 90.8 | Al | 770 | 100 | 322 | $5.0 \times 10^{-6}$ | |
| 28 | 50 | 99.5 | 90 | 5 | 10 | 5 | 2,000 | 9 | 93 | 80 | 70 | 86.6 | Cu | 1,150 | 100 | 339 | $5.2 \times 10^{-6}$ | Cu-SiC |
| 29 | 50 | 99.5 | 90 | 5 | 10 | 5 | 2,000 | 9 | 93 | 80 | 50 | 73.6 | Cu | 1,150 | 100 | 347 | $7.9 \times 10^{-6}$ | |
| 30 | 50 | 99.5 | 90 | 5 | 10 | 5 | 2,000 | 9 | 93 | 80 | 70 | 88.4 | Ag | 1,050 | 100 | 340 | $7.3 \times 10^{-6}$ | Ag-SiC |
| 31 | 50 | 99.5 | 90 | 5 | 10 | 5 | 2,000 | 9 | 93 | 80 | 50 | 76.6 | Ag | 1,050 | 100 | 351 | $9.4 \times 10^{-6}$ | |

*: Comparative example

To prepare the sample for each composite material, the following constituents were mixed in ethanol by means of a ball mill together with 4 wt. % paraffin as a binder:

(a) an SiC powder prepared by the foregoing method having a weight percentage shown in the column "composition of composite material" in Table 1; and
(b) newly prepared pure aluminum powder, copper powder, or silver powder, all having an average particle diameter of 25 μm, constituting the remaining part.

The resultant slurry was spray-dried to obtain granules. The granules were dry-formed to obtain a shape having a diameter of 100 mm and a thickness of 10 mm. The formed body was heated in a vacuum to remove the paraffin. Then, the sample was completed by following the steps described below:

(a) The sample was placed in a high-frequency induction-heating furnace.
(b) The temperature was raised to a temperature shown in the column "baking temperature" in Table 1 at a rate of 600 °C/min.
(c) The temperature was maintained for 10 sec.
(d) The sample was moved to a mold previously heated at 450 °C.
(e) The sample was immediately hot-forged at a pressure of 9 ton/cm$^2$.

The forged body was subjected to measurements of relative density and thermal conductivity. The relative density expressed in percentage was obtained by dividing the density obtained with the submerging method by the theoretical density for the same composition. The thermal conductivity was obtained by the laser flash method at room temperature. These results are also shown in Table 1. Although not shown in Table 1, two more samples were prepared by the following method: The same SiC powder as in Sample 18 in Table 1 and the same aluminum powder as in Table 1 were mixed. One sample had 20 wt. % SiC, and the other 40 wt. % SiC. The two samples were solidified and sintered by the same heating and forging methods as in the samples in Table 1. The sample with 20 wt. % SiC had a relative density of 100% and a thermal conductivity of 250 W/m·K, and the other sample with 40 wt. % SiC had a relative density of 100% and a thermal conductivity of 260 W/m·K.

The obtained results demonstrate the following findings:

(1) A highly heat-conductive silicon carbide powder having a 6H content degree of 90% or more can be obtained by the following process:

(a) a silicon carbide material powder is prepared;
(b) a silicon carbide seed crystal powder having an average particle diameter larger than that of the silicon carbide material powder and a 6H content degree of 98% or more is added to the silicon carbide material powder to prepare a mixed powder; and
(c) the mixed powder is heated at 1,800 °C or higher in an inert-gas atmosphere to sublimate the SiC in the material powder preferentially so that the SiC is condensed and deposited on the seed crystal particles as a 6H-type crystal.

(2) A highly heat-conductive composite material can be obtained even with a composition having 50 wt. % or more SiC by the following process:

(a) the foregoing silicon carbide powder is mixed with an Al or other metal powder;
(b) the mixture is solidified and sintered by hot forging at a temperature not lower than the melting point of the metal.

In particular, an Al-SiC-based composition produces a composite material having a thermal conductivity of 250 W/m·K or more.

(3) Contrarily, when a silicon carbide powder is produced without adding a seed crystal powder under the same heat-treatment conditions as above, the produced composite material shows a thermal conductivity lower than that of Samples of the present invention produced with the same composition under the same compounding conditions.

Example 2

SiC powders were prepared under the same conditions as in Samples 2, 5, 7, 9, 13, 18, and 22 in Example 1. Each of the SiC powders was granulated by a method similar to Example 1. The granules were formed with a dry powder press to obtain the same shape as in Example 1. The formed body was baked at 1,300 to 1,500 °C in an argon gas atmosphere under reduced pressure to remove the paraffin and to adjust the porosity. The resultant SiC porous body was placed on a separately provided pure aluminum, electrolytic copper, or silver plate. The porous body and the metal were heated in a nitrogen gas and mainteined at a temperature shown in Table 2 under "infiltration temperature" for one hour to infiltrate the molten metal into the pores of the porous body. Table 2 shows the relative density, thermal conductivity at room temperature, and CTE of the completed composite materials.

Table 2

| Sample No. | Type of SiC powder (#) | Infiltrating metal | Infiltration temperature (°C) | Composite material | | | | |
|---|---|---|---|---|---|---|---|---|
| | | | | | Amount of SiC | | | |
| | | | | Relative density (%) | (wt.%) | (vol.%) | Thermal conductivity (W/m · K) | CTE(/°C) |
| *32 | 2 | Al | 770 | 99 | 70 | 66.6 | 255 | $7.9 \times 10^{-6}$ |
| 33 | 5 | Al | 770 | 99 | 70 | 66.6 | 325 | $7.9 \times 10^{-6}$ |
| 34 | 7 | Al | 770 | 99 | 70 | 66.6 | 256 | $7.9 \times 10^{-6}$ |
| 35 | 9 | Al | 770 | 99 | 70 | 66.6 | 290 | $7.9 \times 10^{-6}$ |
| 36 | 13 | Al | 770 | 99 | 70 | 66.6 | 350 | $7.9 \times 10^{-6}$ |
| 37 | 18 | Al | 770 | 99 | 70 | 66.6 | 292 | $7.9 \times 10^{-6}$ |
| 38 | 18 | Al | 770 | 99 | 80 | 77.4 | 302 | $6.5 \times 10^{-6}$ |
| 39 | 18 | Al | 770 | 99 | 50 | 46.1 | 275 | $11.0 \times 10^{-6}$ |
| 40 | 18 | Cu | 1,180 | 99 | 50 | 73.6 | 332 | $7.9 \times 10^{-6}$ |
| 41 | 18 | Ag | 1,080 | 99 | 50 | 76.6 | 342 | $9.4 \times 10^{-6}$ |
| 42 | 22 | Al | 770 | 99 | 70 | 66.6 | 325 | $7.9 \times 10^{-6}$ |

*: Comparative example,

#: The type is shown by the sample number in Table 1.

Another group of the same SiC powders having the same sample numbers as used for producing the composite materials by the above-described infiltration method was prepared. Each of the SiC powders was dry-mixed with an aluminum-alloy, pure-copper, or pure-silver powder at a proportion shown in Table 3 under "composition". The aluminum-alloy powder containing 3 wt. % Si rapidly solidified by the gas atomizing method was supplied as a powder having an average particle diameter of 50 μm. Both the copper and silver powders obtained by the electrolytic method were supplied as a powder having an average particle diameter of 70 μm. The mixed powder was formed to obtain the same shape as in Example 1. The formed body was sintered by maintaining it at a temperature shown in Table 3 under "sintering temperature" for one hour in a nitrogen gas. Table 3 shows the relative density, thermal conductivity at room temperature, and CTE of the completed composite materials.

Table 3

| Sample No. | Type of SiC powder (#) | Composition | | Sintering temperature (°C) | Composite material | | |
|---|---|---|---|---|---|---|---|
| *43 | 2 | Amount of SiC (wt. %) | Metal (wt. %) | | Relative density (%) | Thermal conductivity (W/m · K) | CTE (/°C) |
| *43 | 2 | 70 | Al 30 | 770 | 98 | 250 | $7.9\times10^{-6}$ |
| 44 | 5 | 70 | Al 30 | 770 | 98 | 320 | $7.9\times10^{-6}$ |
| 45 | 7 | 70 | Al 30 | 770 | 98 | 250 | $7.9\times10^{-6}$ |
| 46 | 9 | 70 | Al 30 | 770 | 98 | 285 | $7.9\times10^{-6}$ |
| 47 | 13 | 70 | Al 30 | 770 | 97 | 344 | $7.9\times10^{-6}$ |
| 48 | 18 | 70 | Al 30 | 770 | 98 | 289 | $7.9\times10^{-6}$ |
| 49 | 18 | 80 | Al 20 | 770 | 98 | 296 | $6.5\times10^{-6}$ |
| 50 | 18 | 50 | Al 50 | 770 | 98 | 269 | $11.0\times10^{-6}$ |
| 51 | 18 | 50 | Cu 50 | 1,180 | 98 | 325 | $7.9\times10^{-6}$ |
| 52 | 18 | 50 | Ag 50 | 1,080 | 98 | 336 | $9.4\times10^{-6}$ |
| 53 | 22 | 70 | Al 30 | 770 | 98 | 318 | $7.9\times10^{-6}$ |

*: Comparative example,

#: The type is shown by the sample number in Table 1.

Table 4

| Bragg angle 2Θ (degree) | Lattice spacing $d$ (Å) | Intensity ratio of diffraction peaks $I/I_0$(%) | Crystal type (index of plane in 6H type) |
|---|---|---|---|
| 33.76 | 2.6547 | 1 | 15R |
| 34.02 | 2.6351 | 1 | 15R |
| 34.09 | 2.6300 | 1 | 33R |
| 34.21 | 2.6210 | 40 | 6H (101) |
| 35.04 | 2.5611 | 2 | 15R |
| 35.48 | 2.5300 | 2 | 33R |
| 35.72 | 2.5133 | 2 | 15R |
| 35.76 | 2.5110 | 100 | 6H (102) |
| 35.78 | 2.5095 | 2 | 15R |
| 37.70 | 2.3859 | 1 | 15R |
| 37.80 | 2.3800 | 1 | 33R |
| 38.27 | 2.3520 | 20 | 6H (103) |
| 38.86 | 2.3173 | Almost zero | 15R |
| 41.42 | 2.1800 | 1 | 33R |
| 41.54 | 2.1741 | 1 | 15R |
| 41.54 | 2.1740 | 10 | 6H (104) |
| 43.03 | 2.1020 | Almost zero | 15R |
| 43.29 | 2.0900 | Almost zero | 33R |

Table 4   (continued)

| Bragg angle 2Θ (degree) | Lattice spacing $d$ (Å) | Intensity ratio of diffraction peaks $I/I_0$(%) | Crystal type (index of plane in 6H type) |
|---|---|---|---|
| 45.34 | 2.0000 | Almost zero | 33R |
| 53.81 | 1.7036 | 1 | 15R |
| 54.28 | 1.6900 | Almost zero | 33R |
| 56.08 | 1.6400 | Almost zero | 33R |
| 57.98 | 1.5907 | 2 | 15R |
| 59.23 | 1.5600 | 1 | 33R |
| 60.15 | 1.5382 | 2 | 15R |
| 60.21 | 1.5370 | 35 | 6H (110) |

The obtained results demonstrate the following findings:

(1) A highly heat-conductive composite material can be obtained by the following process:

(a) the SiC powder of the present invention having a 6H content degree of 90% or more is prepared by the addition of a silicon carbide seed crystal powder and subsequent heat treatment;
(b) the SiC powder is compounded with Al or another metal by the infiltration or sintering method.

In particular, an Al-SiC-based composition produces a composite material having a thermal conductivity not less than 250 W/m·K at room temperature.
(2) Contrarily, when an SiC powder is produced without adding a silicon carbide seed crystal powder under the same heat-treatment conditions as above, the produced composite material shows a thermal conductivity at room temperature lower than that of the Samples of the present invention produced with the same composition under the same compounding conditions.

Example 3

Eight types of composite materials were prepared by the same manufacturing methods as in Samples 5, 7, 13, 18, 29, and 31 in Example 1, Sample 36 in Example 2, and Sample 47 in Example 3. Fifty samples of each type of composite material were finished to obtain substrates having a length of 200 mm, a width of 200 mm, and a thickness of 3 mm. The sample was mounted as a heat-dissipating substrate on a power module schematically illustrated in Fig. 1. The module was subjected to heat cycle tests including those carried out during the course of the process for mounting its components. The module shown in Fig. 1 has the following components: The second substrate 1 for heat dissipation is made of the foregoing composite material of the present invention. First substrates 2 are placed on the second substrate, have electrically insulating quality, and are made of a ceramic. Although not shown in Fig. 1, copper circuits are formed on the first substrates 2. Silicon semiconductor elements 3 are mounted on the first substrates 2. A radiator 4 is placed underneath the second substrate 1 for heat dissipation. Although the radiator used in Example 3 was a water-cooled jacket type, other types such as an air-cooled fin type are also available. Figure 1 omits the wiring for the semiconductor elements and other details. In Example 3, the module mounts six Si semiconductor elements on the first ceramic substrates.
Before the mounting work, the main surface of the second substrate was previously provided with an electroless-nickel-plated layer having an average thickness of 5 μm and an electrolytic-nickel-plated layer having an average thickness of 3 μm, because the first substrates cannot be soldered directly onto the second substrate. Four second-substrate samples of each type of composite material were provided with a copper wire, 1 mm in diameter, attached perpendicularly to the nickel-plated surface with a semi-spherical Ag-Sn-based solder having a diameter of 5 mm. The bonding strength between the plated layer and the substrate was measured by pulling the copper wire perpendicularly to the plated layer with the substrate itself being fixed to a tool. The test results showed that the plated layer of every sample withstood a tensile force of 1 kg/mm$^2$ without peeling from the substrate. Another group of 10 second-substrate samples provided with the plated layer was sampled from each type of composite material. The sample was subjected to a heat cycle test in which the sample was cooled at -60 °C for 30 minutes and then heated at 150 °C for 30 minutes, and this cycle was repeated 1,000 times. Then, the sample was subjected to the same bonding strength test as before. The test results showed that every sample could satisfactorily withstand the same level of tensile force as before. These test results proved that a substrate made of the composite material of the present invention can give sufficient bonding strength to a plated layer provided on it.

Next, two groups of 18 ceramic substrates having copper circuits formed on them were prepared as the first substrate to be mounted on the second substrate. One group called "Substrate *A*" was made of an aluminum nitride ceramic having a thermal conductivity of 150 W/m·K, a CTE of $4.5 \times 10^{-6}/°C$, and a 3-point bending strength of 450 MPa. The other group called "Substrate *B*' was made of a silicon nitride ceramic having a thermal conductivity of 120 W/m·K, a CTE of $3.7 \times 10^{-6}/°C$, and a 3-point bending strength of 1,300 MPa. All the first substrates have a length of 90 mm, a width of 60 mm, and a thickness of 1 mm. These first substrates were placed in rows of two and in columns of three at equal intervals on the nickel-plated main surface of the second substrate having a size of 200 mm square and fixed with an Ag-Sn-based solder. The second substrate was fixed to the water-cooled jacket with bolts, with a silicon-oil compound applied at the interface between the under face of the substrate and the jacket. The fixing holes in the second substrate were formed by the following method: First, prepared holes were provided at the four corners of the substrate when the material was supplied. Next, the prepared holes were enlarged to a diameter of 3 mm by irradiation of laser beams from a carbon dioxide laser. This processing could be carried out with high precision and high speed in comparison with other object materials, such as other ceramics, a Cu-W composite, and a Cu-Mo composite. This tendency became notable particularly as the thermal conductivity increased.

A group of three sample modules having "Substrate *A*" as the first substrates and another group of three sample modules having "Substrate *B*' as the first substrates were used. These samples were subjected to a heat cycle test in which the sample was cooled and then heated under the same conditions as before, and this cycle was repeated 2,000 times. The output of the module was measured at 500-cycle intervals to observe the variation of the output. All the sample modules showed no output reduction after 1,000 cycles, a benchmark at which a module is judged to be satisfactory in actual use. The heat cycle test was extended up to 2,000 cycles without showing any reduction in the output. The test results indicated that a power module having the second substrate made of the silicon carbide-based composite material of the present invention has a satisfactory performance level in practical use.

Incidentally, to further evaluate the performance, heat-dissipating substrates made of the material of the present invention were also mounted on semiconductor element-mounting devices such as a large-sized personal computer having a small operating capacity. The test results were satisfactory in reliability and practical performance.

## Claims

1.  A silicon carbide powder of which the summation of the peak intensities of X-ray diffraction peaks obtained on the (101), (102), (103), (104), and (110) planes of 6H-type crystal grains in the range of Bragg angle 2Θ from 30 to 61 degrees is 90% or more of the summation of the peak intensities of all the X-ray diffraction peaks in the same range of Bragg angle when tested by using the CuK$\alpha$ line.

2.  The silicon carbide powder as defined in claim 1, having an average particle diameter of 0.1 to 200 µm.

3.  A composite material comprising:

    (a) a metal matrix; and
    (b) particles of the silicon carbide powder defined in claim 1 or 2, the particles being dispersed in the metal matrix.

4.  The composite material as defined in claim 3, wherein:

    (a) the metal in the metal matrix consists mainly of aluminum; and
    (b) the amount of the particles of the silicon carbide powder is 50 to 90 wt. %.

5.  A semiconductor device made with a composite material defined in claim 3 or 4.

6.  A method for manufacturing a silicon carbide powder, the method comprising the steps of:

    (a) preparing a silicon carbide material powder;
    (b) adding a seed crystal powder to the silicon carbide material powder to prepare a mixed powder, wherein the seed crystal powder has:

(b1) a larger average particle diameter than that of the silicon carbide material powder; and

(b2) contains 98% or more 6H-type crystal particles; and

(c) heat-treating the mixed powder at 1,800 °C or higher in an inert gas.

7. The method for manufacturing a silicon carbide powder as defined in claim 6, wherein the seed crystal powder contains 100 ppm or less Fe.

8. A method for manufacturing a silicon carbide powder as defined in claim 6, wherein the seed crystal powder has an average particle diameter 2 or more times that of the silicon carbide material powder.

9. A method for manufacturing a silicon carbide powder as defined in claim 6, wherein the silicon carbide material powder has an average particle diameter of 10 μm or less.

10. A method for manufacturing a silicon carbide powder as defined in claim 6, 7, 8, or 9, wherein the added amount of the seed crystal powder is 5 wt. % or more of the mixed powder.

11. A silicon carbide powder comprising no less than about 90% of 6H-type silicon carbide crystals.

12. The silicon carbide powder as defined in claim 11, having an average particle diameter of 0.1 to 200 μm.

13. A composite material comprising:

(a) a metal matrix; and

(b) the silicon carbide powder defined in claim 11.

FIG. 1

Semiconductor element

3

First substrate

2

Second substrate

1

4 Radiator

FIG. 2